# EUROPEAN PATENT SPECIFICATION

(11) **EP 2 157 696 B1**
(45) Date of publication and mention of the grant of the patent: **06.10.2010**
(21) Application number: 08014720.0
(22) Date of filing: 19.08.2008
(51) Int. Cl.: H03K 5/13, G04F 1/00

(54) **Timebase circuit arrangements**
Zeitbasis-Schaltungsanordnungen
Agencements de circuit de base de temps

(43) Date of publication of application: 24.02.2010
(73) Proprietor: Siemens Milltronics Process Instruments Inc., Peterborough, Ontario K9J 7B1 (CA)
(72) Inventor: Duivenvoorden, Jos, Trent River K0L 2Z0,ON (CA)
(74) Representative: Maier, Daniel Oliver

(56) References cited:
- US-A- 3 671 751
- US-A- 3 724 201

## Description

This invention relates to timebase circuits for use in electronic apparatus. The invention is of particular usefulness in the field of radar-based measurement systems, such as level measurement in industrial process control, but may equally be of utility in other applications that need a very accurate timebase, such as ultrasonic, TDR (Time Domain Reflectometry) or oscilloscope measurement equipment.

Radar-based pulse echo measurement systems operate essentially by measuring time of flight of a pulse. Conventional systems are designed to produce accuracies of the order of a few millimetres and to deal with levels which change relatively slowly. There is a need in the industry to provide sub-millimetre accuracy, and to cope with more rapidly changing levels.

Current systems which attempt to address these needs are experiencing timebase jitter which translates to inaccuracy from measurement shot to measurement shot. The accuracy can be improved somewhat by averaging over a number of measurements. However, this involves a relatively long time settlement, and a slow response to rapidly changing tank levels.

The present invention, from one aspect, provides a timebase signal generating circuit as defined in claim 1.

The invention is based upon realising the timebase in the optical domain. This allows use of frequencies which are capable of giving a timebase resolution equivalent to 0.1 mm of level, and a high degree of immunity to crosstalk from adjacent circuits.

Preferably, the optical detector and the integrator are formed by a photon counter. This provides an off-the-shelf approach to forming both elements in a single item.

Alternatively, the optical detector may comprise a light sensitive resistor.

The light source is preferably a coherent light source, such as a laser, preferably is a resonant laser; this minimises temperature effects. Alternatively the light source may be a light-emitting diode.

The invention also provides a radar-based pulse echo level measurement system including the timebase circuit defined above. Such a system may have sub-millimetre accuracy.

From another aspect, the invention provides a method of generating a timebase signal as defined in claim 8.

The detection and integration are preferably performed as a single step by photon counting.

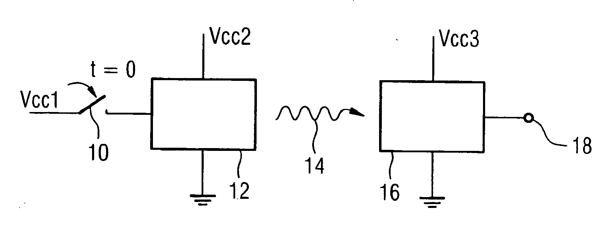

An embodiment of the invention will now be described, by way of example only, with reference to the drawing in which the Figure is a schematic block diagram illustrating one form of the invention.

The problem of timebase accuracy outlined above can be addressed by using a higher timebase frequency. For example, for a timebase resolution equivalent to 0.1 mm the wavelength in vacuum should be c/f (speed of light divided by frequency), which implies a frequency of 3 THz (3·10⁸/10⁻⁴). In a medium other than vacuum, the frequency changes with the square root of the dielectric constant of the medium. The invention is based upon using light to provide the timebase. Referring to the drawing, the timebase is started at t = 0 by a trigger such as switch 10 applying a controlled voltage Vcc1 to an optical source 12 to produce a light beam 14. the light beam 14 is detected and integrated by an optical detector/integrator 16. When the integrated value reaches a preset level, an output 18 is produced, suitably in the form of a clock pulse. This provides a highly accurate timebase suitable for level detecting radar, or other applications requiring a similar degree of accuracy.

The light source 12 is typically either a light-emitting diode or a coherent light source such as a laser. A preferred arrangement is to use a resonant laser, in which the frequency is determined by the cavity dimensions and is highly independent of temperature.

The light source may operate in the range from infrared to ultraviolet. For use in radar based pulse echo systems it is preferred to use high frequency light with a frequency above 300 GHz.

The light beam 14 can be guided or unguided; in other words it may be transmitted via a guide such as an optical fibre or fibre optic bundle, or may pass through free space.

The optical detector/integrator 16 in one form of the invention comprises a photon counter. Photon counters are well known in the art and are commercially available. The use of a photon counter is advantageous in that accumulating the count of detected photons provides integration directly, the accumulated count forming a measure of evolved time.

However, other forms of optical detector/integrator may be used. For example, a light-influenced resistor or a photodiode may be used, in conjunction with an integrating component such as a capacitor.

One prior art photon energy detector comprising a photo diode and an integrator is disclosed in United States Patent number 3,671,751 to Kortge et al.

The invention thus provides a simple manner of producing a high quality timebase of a frequency suitable for use in radar-based level measurement systems. Forming the timebase in the optical domain provides a high degree of immunity from crosstalk and other interference.

## Claims

1. A timebase signal generating circuit comprising an optical source (12) producing a light beam (14) of constant intensity, an optical detector (16) arranged to detect the light beam, and an integrator (16) connected to integrate the detected signal and to provide said timebase signal on a timing output (18) when a preset integrated value is achieved.

2. The circuit of claim 1, in which the optical detector and the integrator are formed by a photon counter (16).

3. The circuit of claim 1, in which the optical detector (16) comprises a light sensitive resistor.

4. The circuit of any preceding claim, in which the light source (12) is a laser.

5. The circuit of claim 4, in which the laser is a resonant laser.

6. The circuit of any of claims 1 to 3, in which the light source (12) is a light-emitting diode.

7. A radar-based pulse echo level measurement system including the timebase circuit of any preceding claim.

8. A method of generating a timebase signal, comprising generating a constant intensity light beam, detecting the light beam, integrating the detected signal, and generating said timebase signal on a timing output when a preset integrated value is achieved.

9. The method of claim 8, in which the detection and integration are performed as a single step by photon counting.

## Patentansprüche

1. Zeitbasissignalerzeugender Schaltkreis, der Folgendes umfasst: eine Lichtquelle (12), die einen Lichtstrahl (14) von konstanter Intensität erzeugt, einen optischen Detektor (16), der dafür angeordnet ist, den Lichtstrahl zu erfassen, und einen Integrator (16), der dafür angeschlossen ist, dass er das erfasste Signal integriert und das Zeitbasissignal an einem Zeitgeberausgang (18) bereitstellt, wenn ein voreingestellter integrierter Wert erreicht wird.

2. Schaltkreis nach Anspruch 1, bei dem der optische Detektor und der Integrator von einem Photonenzählrohr (16) gebildet werden.

3. Schaltkreis nach Anspruch 1, bei dem der optische Detektor (16) einen lichtempfindlichen Widerstand umfasst.

4. Schaltkreis nach einem der vorhergehenden Ansprüche, bei dem es sich bei der Lichtquelle (12) um einen Laser handelt.

5. Schaltkreis nach Anspruch 4, bei dem es sich bei dem Laser um einen resonanten Laser handelt.

6. Schaltkreis nach einem der Ansprüche 1 bis 3, bei dem es sich bei der Lichtquelle (12) um eine Leuchtdiode handelt.

7. Impulsecho-Pegelmesssystem auf Radarbasis, welches den Zeitbasisschaltkreis nach einem der vorhergehenden Ansprüche aufweist.

8. Verfahren zum Erzeugen eines Zeitbasissignals, das Folgendes umfasst: Erzeugen eines Lichtstrahls von konstanter Intensität, Erfassen des Lichtstrahls, Integrieren des erfassten Signals und Erzeugen des Zeitbasissignals an einem Zeitgeberausgang, wenn ein voreingestellter integrierter Wert erreicht wird.

9. Verfahren nach Anspruch 8, bei dem das Erfassen und Integrieren durch Photonenzählung als ein Schritt durchgeführt werden.

## Revendications

1. Agencement de circuit générateur de signal de base de temps comprenant une source ( 12 ) optique produisant un faisceau ( 14 ) lumineux d'intensité constante, un détecteur ( 16 ) optique disposé de manière à détecter le faisceau lumineux et un intégrateur ( 16 ) connecté pour intégrer le signal détecté et pour fournir le signal de base de temps sur une sortie ( 18 ) de synchronisation lorsqu'une valeur intégrée préfixée est atteinte.

2. Circuit suivant la revendication 1, dans lequel le détecteur optique et l'intégrateur sont formés par un compteur ( 16 ) de photon.

3. Circuit suivant la revendication 1, dans lequel le détecteur ( 16 ) optique comprend une résistance sensible à la lumière.

4. Circuit suivant l'une quelconque des revendications précédentes, dans lequel la source ( 12 ) lumineuse est un laser.

5. Circuit suivant la revendication 4, dans lequel le laser est un laser résonant.

6. Circuit suivant l'une quelconque des revendications 1 à 3, dans lequel la source ( 12 ) lumineuse est une diode électroluminescente.

7. Système de mesure du niveau d'écho d'impulsion à base de radar comprenant le circuit de base de temps suivant l'une quelconque des revendications précédentes.

8. Procédé de production d'un signal de base de temps, dans lequel on produit un faisceau lumineux d'intensité constante, on détecte le faisceau lumineux, on intègre le signal détecté et on produit le signal de base de temps sur une sortie de synchronisation lorsqu'une valeur intégrée, fixée à l'avance, est atteinte.

9. Procédé suivant la revendication 8, dans lequel on effectue la détection et l'intégration sous la forme d'un stade unique en comptant des photons.
